# EUROPÄISCHE PATENTSCHRIFT

(11) **EP 2 149 990 B1**
(45) Veröffentlichungstag und Bekanntmachung des Hinweises auf die Patenterteilung: **25.05.2011**
(21) Anmeldenummer: 08075672.9
(22) Anmeldetag: 29.07.2008
(51) Int. Cl.: H03M 1/12

(54) **System, insbesondere zur Digitalisierung eines zeit- und wertekontinuierlichen periodischen Signals mit einer fest vorgegebenen Anzahl an Abtastwerten pro Periode**
System, particularly for digitalising a periodic signal with continuous time and value with a fixed number of scan values per period
Système, en particulier destiné à la numérisation d'un signal périodique à temps et valeur continus ayant un nombre fixe prédéterminé de valeurs de balayage par période

(43) Veröffentlichungstag der Anmeldung: 03.02.2010
(73) Patentinhaber: Siemens Aktiengesellschaft, 80333 München (DE)
(72) Erfinder: Danner, Andreas, 90425 Nürnberg (DE); Fleischmann, Thomas, 90552 Röthenbach (DE)

(56) Entgegenhaltungen:
- EP-A- 0 845 865
- WO-A-03/065590
- GB-A- 2 255 681
- US-A1- 2006 103 555

## Beschreibung

Die Erfindung betrifft ein System, insbesondere zur Digitalisierung eines zeit- und wertekontinuierlichen periodischen Signals mit jeweils einer fest vorgegebenen Anzahl an Abtastwerten pro Periode, gemäß dem Oberbegriff des Anspruchs 1.

Die Digitalisierung von analogen Wechselspannungen mittels AD-Wandlern ist allgemein bekannt. Ein spezieller häufig eingesetzter AD-Wandler ist der sogenannte Delta-Sigma-Wandler, der eine schnelle Digitalisierung eines analogen Wechselsignals mit einer hohen Auflösung von beispielsweise 24 Bit ermöglicht. Der von einem Delta-Sigma-Wandler erzeugte Datenstrom (der 24 Bit-Datenwörter) wird dabei in einem von außen angelegten fest vorgegebenen Arbeitstakt erzeugt. Der Arbeitstakt ist mindestens um den Oversamplingfaktor größer als die höchste aufzulösende Frequenz des Eingangssignals; ist diese 100 kHz, so ist bei einem Oversamplingfaktor von 256 ein Arbeitstakt von 2,56 MHz sinnvoll.

Soll für eine digitalisierte Wechselspannung eine FFT (Fast-Fourier-Transformation) berechnet werden, so ist pro Periode der Wechselspannung eine feste Anzahl von Tastpunkten pro Periode erforderlich, vorzugsweise 2ⁿ Abtastpunkte pro Periode mit n als positiver ganzer Zahl, wobei die Berechnung der FFT über eine Vielzahl von Perioden erfolgt, welche die sogenannte Messperiode bilden, über welche die Grundfrequenz des Wechselsignals im wesentlichen konstant ist.

Ändert sich die Grundfrequenz des Wechselsignals, muss der feste Arbeitstakt des Ausgangsstroms des Delta-Sigma-Wandlers z.B. mittels Interpolation in einen Datenstrom mit der gewünschten festen Anzahl von Abtastpunkten pro Periode umgerechnet werden. Dies ist rechenintensiv und relativ aufwändig.

Alternativ können aber auch Successive-Approximation-AD-Wandler eingesetzt werden, die relativ teuer und in der Genauigkeit eingeschränkt sind.

Aus der WO03/065590 ist weiter eine elektronische Schaltung bekannt, die einen AD-Wandler mit einem üblicherweise quarzgesteuerten Arbeitstakt umfasst, der als Delta-Sigma-Wandler ausgebildet ist. Der Ausgangs-Datenstrom des Delta-Sigma-Wandlers wird einer Prozessoreinheit zugeführt, die mittels eines digital einstellbaren Oszillators ein abgeleitetes Modulationssignal erzeugt, das zu einem Mischer (Mixer) zurückgeführt wird, der dem Delta-Sigma-Wandler vorgeschaltet ist. Der Mischer erzeugt durch Mischung aus dem an seinem Eingang anliegenden analogen Wechselsignal und dem Modulationssignal ein analoges Differenzfrequenzsignal. Über das von der Prozessoreinheit über den Oszillator zurückgeführte Modulationssignal wird der Mischer jeweils so eingestellt, dass die Grundfrequenz des Differenzfrequenzsignals konstant ist.

Ein Sigma-Delta-Wandler (AD-Wandler) mit einem Dezimationsfilter ist aus der US 2006/103555 bekannt.

Ferner ist aus der EP 0845865 bekannt, den Arbeitstakt eines AD-Wandlers von einer Verzögerungseinheit abhängig vom Wechselsignal steuern zu lassen.

Die Aufgabe der Erfindung ist es, mit technisch relativ geringem Aufwand ein zeit- und wertekontinuierliches periodisches Signal mit jeweils einer fest vorgegebenen Anzahl von Abtastwerten pro Periode zu digitalisieren.

Die Aufgabe wird durch die Merkmale des Anspruchs 1 gelöst, die Unteransprüche stellen vorteilhafte Ausgestaltungen dar.

Die Lösung sieht vor, dass der Arbeitstakt jeweils in Abhängigkeit von einer Signaleigenschaft des Wechselsignals durch einen digital einstellbaren Oszillator erzeugt wird. Der Erfindung liegt der Grundgedanke zugrunde, das Ausgangssignal des Oszillators mittels einer Signaleigenschaft des Wechselsignals zu steuern. Die Steuerung erfolgt so, dass eine dem Arbeitstakt entsprechende Digitalzahl an den Eingang des Oszillators gelegt wird, die also der durch den Oszillator zu erzeugenden Ausgangsfrequenz entspricht und die von einer Signaleigenschaft des Wechselsignals abhängt. Durch das Oversampling des AD-Wandlers ist die Zahl der Abtastpunkte pro Periode deutlich größer und der zeitliche Abstand zwischen zwei Abtastpunkten stark verkleinert. Entsprechend ist der Fehler, den man macht, wenn die Abtastpunkte nicht symmetrisch innerhalb einer Periode liegen, d.h. wenn also der Abstand des ersten Abtastpunktes vom Nulldurchgang am Beginn der Periode nicht gleich dem zeitlichen Abstand zweier Abtastpunkte ist. Praktisch wird dieser zeitliche Fehler noch dadurch verringert, dass die Zahl der Abtastpunkte pro Periode zusätzlich zu dem Oversampling-Faktor mit einer Zahl multipliziert wird, welche meist sogar größer als 1000 ist, um auch höhere Frequenzanteile zu erfassen (z.B. die 512. Oberwelle).

Vorteilhafterweise wird anhand des zweiten Datenstroms jeweils die Grundfrequenz als Signaleigenschaften des Wechselsignals ermittelt und die Frequenz des digital einstellbaren Oszillators und daraus abgeleitet die Abtastfrequenz auf ein Vielfaches der Grundfrequenz eingestellt, insbesondere ein ganzzahliges Vielfaches.

Technisch einfach ist es, wenn die Grundfrequenz mit Hilfe eines digitalen Signalprozessors (Digital Signal Processor DSP) oder eines digitalen Microcontrollers (Micro Control Unit MCU) ermittelt und der Oszillator vom Signalprozessor bzw. Microcontroller digital eingestellt wird. Der Signalprozessor oder Microcontoller stellt also nicht nur die vom Oszillator zu erzeugende Grundfrequenz ein, sondern ermittelt diese auch selbst anhand des am Ausgang des AD-Wandlers zur Verfügung stehenden Datenstroms.

Zur Erhöhung der Genauigkeit bei einer nachfolgenden Verarbeitung des zweiten Datenstroms als Abbild des digitalisierten Wechselsignals, insbesondere zur Berechnung der FFT, wird vorgeschlagen, dass die Abtastfrequenz über die Frequenz des digital einstellbaren Oszillators jeweils so eingestellt wird, dass die Anzahl der Abtastpunkte pro Periodendauer der Grundfrequenz konstant ist.

Die nachfolgende Verarbeitung lässt sich weiter vereinfachen, wenn die Anzahl der Abtastpunkte pro Periodendauer der Grundfrequenz eine Zweierpotenz (2ⁿ bzw. 2 hoch einer ganzen Zahl n) ist.

Zur Erhöhung der Genauigkeit der Informationen, die aus dem digitalisierten Wechselsignal ermittelt werden, wird vorgeschlagen, dass anhand der ermittelten Grundfrequenz eine zeitliche Messperiode (z.B. bezogen auf PMD für die Effektivwertbestimmung) festgelegt wird.

Zweckmäßigerweise ist die Messperiode ein ganzzahliges Vielfaches der ermittelten momentanen Grundfrequenz.

Vorteilhafterweise wird die FFT über die Messperiode durchgeführt.

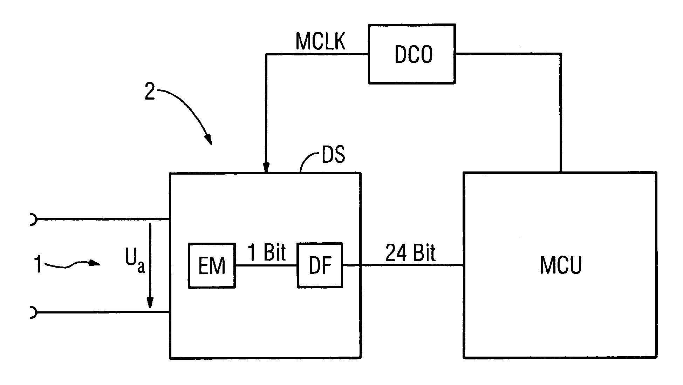

Die Erfindung wird nachfolgend anhand eines Ausführungsbeispiels näher beschrieben. Die einzige Figur zeigt ein System zur Digitalisierung einer analogen Wechselspannung Ua als Beispiel für ein analoges Wechselsignal 1.

Die Wechselspannung Ua mit einer Grundfrequenz von 50 Hz liegt am Eingang eines AD-Wandlers 2 an, der als Delta-Sigma-Wandler DS ausgebildet ist. Die Grundfrequenz schwankt zeitlich zwischen 45 Hz und 65 Hz, wobei sich Änderungen der Grundfrequenz relativ langsam vollziehen, also über viele Perioden der Wechselspannung Ua.

Der AD-Wandler 2 umfasst einen 1-Bit-Modulator, welcher die Wechselspannung Ua mit einem Arbeitstakt MCLK von 2,6 MHz in einen Datenstrom (ersten Datenstrom) von zeitlich unmittelbar aufeinanderfolgenden 1-Bit-Datenwörtern umwandelt. Ein nachfolgendes Dezimationsfilter DF wandelt den Datenstrom der unmittelbar aufeinanderfolgenden 1-Bit-Datenwörtern in zeitlich unmittelbar aufeinanderfolgende 24-Bit-Datenwörtern um, also in Datenwörter mit einer Breite von 24 Bit, wobei ein 24-Bit-Datenwort jeweils aus 256 der 1-Bit-Datenwörter agregiert wird, was einem Oversampling-Faktor von 256 entspricht. Dividiert man den Arbeitstakt von 2,56 MHz durch die Zahl der agregierten Datenwörter, hier also 256, so erhält man hier 100 kHz als die größte Abtastfrequenz der Wechselspannung Ua.

Der AD-Wandler 2 ist mit einem digitalen Microcontroller (Micro Control Unit) MCU verbunden, der den Ausgangsdatenstrom (zweiten Datenstrom) des AD-Wandlers 2 auswertet. Bei der Auswertung wird die Grundfrequenz der analogen Wechselspannung Ua als die hier wesentliche Signaleigenschaft der analogen Wechselspannung Ua ermittelt. Die Funktionen des digitalen Microcontrollers MCU können selbstverständlich auch von einem digitalen Signalprozessor (Digital Signal Processor) und dergleichen ausgeführt werden.

Andererseits stellt der Microcontroller MCU den Arbeitstakt MCLK des AD-Wandlers 2 über einen digital einstellbaren Oszillator DCO (Digital Control Oscillator) ein. Die Vorgabe bzw. Einstellung erfolgt digital, also als Digitalzahl, die an den Eingang des Oszillators DCO gelegt wird. Der Arbeitstakt MCLK wird so gewählt, dass die Abtastfrequenz des zweiten Datenstroms des AD-Wandlers 2 nicht nur ein ganzzahliges Vielfaches der Grundfrequenz ist, sondern dass die Anzahl der Abtastpunkte pro Periodendauer der Grundfrequenz jeweils eine Zweierpotenz ist (2 hoch einer ganzen Zahl oder 2^{P} mit p gleich einer ganzen Zahl). Das bedeutet auch, dass die Anzahl der Abtastpunkte pro Periodendauer der Grundfrequenz konstant ist. Diese Forderung lässt sich für eine Vielzahl von unmittelbar aufeinanderfolgenden Perioden der Wechselspannung Ua sicherstellen, wenn sich deren Grundfrequenz zeitlich nur langsam ändert. Dabei bildet ein ganzzahliges Vielfaches der Periode der Wechselspannung Ua jeweils eine Messperiode, welche zur Berechnung einer FFT verwendet werden kann, beispielsweise um den Effektivwert der Wechselspannung Ua oder abgeleitet des Wechselstroms zu berechnen.

Der Microcontroller MCU liegt hier genaugenommen in der Rückkopplungsschleife, die über den Oszillator DCO läuft.

Der digital einstellbare Oszillator DCO kann sich alternativ auch in einem DDS-Schaltkreis (DDS-IC) befinden, der speziell eine direkte digitale Synthese (Direct Digital Synthesis DDS) durchführt. Mit einem DDS-Schaltkreis kann der Arbeitstakt MCLK z.B. in einem sehr großen Frequenzbereich mit sehr hoher Genauigkeit erzeugt werden. Ein DDS-Schaltkreis mit 75 MHz Arbeitsfrequenz und einem 28-Bit-Einstellregister kann ein Ausgangssignal erzeugen, das in einem Bereich zwischen 0 und 75/2 Hz liegt. Die Einstellgenauigkeit liegt bei 75 MHz/2²⁸, das sind ca. 0,279 Hz. Berücksichtigt man einen Oversampling-Faktor von 256, so lässt sich der Arbeitstakt immerhin mit einer Genauigkeit von 0,279Hz/256 also von ungefähr 0,001 Hz einstellen. Zur Erzeugung des Arbeitstakts MCLK für den AD-Wandler 2 wird dem DDS-Schaltkreis noch ein Schmitt-Trigger nachgeschaltet.

## Patentansprüche

1. System, insbesondere zur Digitalisierung eines zeit- und wertekontinuierlichen periodischen Signals mit jeweils einer fest vorgegebenen Anzahl an Abtastwerten pro Periode,
mit einem AD-Wandler (2), insbesondere einem Delta-Sigma-Wandler, zur Digitalisierung eines am Eingang des AD-Wandlers (2) anliegenden analogen Wechselsignals (Ua),
der einen Ein-Bit-Modulator umfasst, welcher das Wechselsignal (Ua) mit vorgegebenem Arbeitstakt (MCLK) in einen ersten Datenstrom von zeitlich unmittelbar aufeinanderfolgenden 1-Bit-Datenwörtern umwandelt,
mit einem nachfolgenden Dezimationsfilter (DF), das eine vorgegebene Anzahl der zeitlich unmittelbar aufeinanderfolgenden 1-Bit- Datenwörter des ersten Datenstroms jeweils in zeitlich unmittelbar aufeinanderfolgende n-Bit-Datenwörter agregiert, die einen zweiten Datenstrom bilden, der einer Digitalisierung des Wechselsignals mit einer Abtastfrequenz entspricht, die sich aus dem Arbeitstakt (MCLK) und der vorgegebenen Anzahl durch Division ableitet,
**dadurch gekennzeichnet,**
**dass** der Arbeitstakt (MCLK) in Abhängigkeit von einer Signaleigenschaft des Wechselsignals (Ua) durch einen digital einstellbaren Oszillator (DCO) erzeugt wird, und dass anhand des zweiten Datenstroms jeweils die Grundfrequenz als Signaleigenschaft des Wechselsignals (Ua) ermittelt und die Frequenz des digital einstellbaren Oszillators (DCO) und daraus abgeleitet die Abtastfrequenz auf ein Vielfaches der Grundfrequenz eingestellt wird.

2. System nach Anspruch 1,
**dadurch gekennzeichnet,**
**dass** die Grundfrequenz mit Hilfe eines digitalen Signalprozessors (DSP) oder eines digitalen Microcontrollers (MCU) ermittelt und der Oszillator vom Signalprozessor (DSP) bzw. Microcontroller (MCU) digital eingestellt wird.

3. System nach Anspruch 1 oder 2,
**dadurch gekennzeichnet,**
**dass** die Abtastfrequenz über die Frequenz des digital einstellbaren Oszillators jeweils so eingestellt wird, dass die Anzahl der Abtastpunkte pro Periodendauer der Grundfrequenz konstant ist.

4. System nach Anspruch 3,
**dadurch gekennzeichnet,**
**dass** die Anzahl der Abtastpunkte pro Periodendauer der Grundfrequenz eine Zweierpotenz ist.

5. System nach einem der Ansprüche 1 bis 4,
**dadurch gekennzeichnet,**
**dass** anhand der ermittelten Grundfrequenz eine zeitliche Messperiode festgelegt wird.

6. System nach Anspruch 5,
**dadurch gekennzeichnet,**
**dass** die Messperiode ein ganzzahliges Vielfaches der jeweils ermittelten momentanen Grundfrequenz ist.

7. System nach einem der Ansprüche 1 bis 6,
**dadurch gekennzeichnet,**
**dass** über die Messperiode jeweils eine FFT ausgeführt wird.

## Claims

1. System, in particular for digitizing a time-continuous and value-continuous periodic signal with a respective firmly predefined number of samples per period,
having an A/D converter (2), in particular a delta-sigma converter, for digitizing an analog AC signal (Ua) applied to the input of the A/D converter (2), said converter comprising a single-bit modulator which converts the AC signal (Ua) into a first data stream of temporally immediately successive single-bit data words at a predefined operating clock rate (MCLK), having a downstream decimation filter (DF) which aggregates a predefined number of temporally immediately successive single-bit data words in the first data stream into respective temporally immediately successive n-bit data words which form a second data stream which corresponds to a digitization of the AC signal at a sampling frequency which is derived from the operating clock rate (MCLK) and the predefined number by means of division,
**characterized in that**
the operating clock rate (MCLK) is generated by a digitally adjustable oscillator (DCO) on the basis of a signal characteristic of the AC signal (Ua), and **in that** the second data stream is used to respectively determine the fundamental frequency as a signal characteristic of the AC signal (Ua), and the frequency of the digitally adjustable oscillator (DCO) and the sampling frequency derived therefrom are set to a multiple of the fundamental frequency.

2. System according to Claim 1,
**characterized in that**
the fundamental frequency is determined with the aid of a digital signal processor (DSP) or a digital microcontroller (MCU), and the oscillator is digitally adjusted by the signal processor (DSP) or microcontroller (MCU).

3. System according to Claim 1 or 2,
**characterized in that**
the sampling frequency is respectively set using the frequency of the digitally adjustable oscillator in such a manner that the number of sampling points per period duration of the fundamental frequency is constant.

4. System according to Claim 3,
**characterized in that**
the number of sampling points per period duration of the fundamental frequency is a power of two.

5. System according to one of Claims 1 to 4,
**characterized in that**
the fundamental frequency determined is used to define a temporal measuring period.

6. System according to Claim 5,
**characterized in that**
the measuring period is an integer multiple of the respective instantaneous fundamental frequency determined.

7. System according to one of Claims 1 to 6,
**characterized in that**
a respective FFT is carried out over the measuring period.

## Revendications

1. Système, notamment de numérisation d'un signal périodique à temps et à valeur continus, ayant respectivement un nombre fixe déterminé à l'avance de valeurs d'échantillonage par période,
comprenant un convertisseur ( 2 ) analogique-numérique, notamment un convertisseur Delta-Sigma de numérisation d'un signal ( Ua ) alternatif analogique appliqué à l'entrée du convertisseur analogique-numérique, qui comprend un modulateur à un bit, qui transforme le signal ( Ua ) alternatif par une cadence ( MCLK ) de travail prescrite en un premier courant de données de mots de données à un bit se succédant directement dans le temps,
comprenant un filtre ( DF ) de décimation, qui agrège un nombre prescrit des mots de données à un bit se succédant directement dans le temps du premier courant de données respectivement en des mots de données à n bit se succédant directement dans le temps et formant un deuxième courant de données, qui correspond à une numérisation du signal alternatif par une fréquence d'échantillonage qui se déduit par division de la cadence ( MCLK ) de travail et du nombre prescrit,
**caractérisé**
**en ce que** la cadence ( MCLK ) de travail est produite en fonction d'une propriété du signal ( Ua ) alternatif par un oscillateur ( DCO ) réglable numériquement, et
**en ce qu'**au moyen du deuxième courant de données, respectivement la fréquence fondamentale est déterminée en tant que propriété du signal ( Ua ) alternatif et la fréquence de l'oscillateur ( DCO ) réglable numériquement et la fréquence d'échantillonage qui s'en déduit est réglée sur un multiple de la fréquence fondamentale.

2. Système suivant la revendication 1,
**caractérisé**
**en ce que** la fréquence fondamentale est déterminée à l'aide d'un processeur ( DSP ) numérique de signal ou d'un microdispositif ( MCU ) numérique de commande et l'oscillateur est réglé numériquement par le processeur ( DSP ) de signal ou par le microdispositif ( MCU ) de commande.

3. Système suivant la revendication 1 ou 2,
**caractérisé**
**en ce que** la fréquence d'échantillonage est réglée par la fréquence de l'oscillateur réglable numériquement, respectivement de manière à ce que le nombre des points d'échantillonage par durée de période de la fréquence fondamentale soit constant.

4. Système suivant la revendication 3,
**caractérisé**
**en ce que** le nombre des points d'échantillonage par durée de la période de la fréquence fondamentale est une puissance de deux.

5. Système suivant l'une des revendications 1 à 4,
**caractérisé**
**en ce qu'**une période de mesure temporelle est fixée au moyen de la fréquence fondamentale déterminée.

6. Système suivant la revendication 5,
**caractérisé**
**en ce que** la période de mesure est un multiple en nombre entier de la fréquence fondamentale instantannée déterminée respectivement.

7. Système suivant l'une des revendications 1 à 6,
**caractérisé**
**en ce que** respectivement une FFT est réalisée sur la période de mesure.
